# EUROPEAN PATENT APPLICATION

(11) **EP 4 601 190 A1**
(43) Date of publication of application: **13.08.2025**
(21) Application number: 23891768.6
(22) Date of filing: 11.08.2023
(51) Int. Cl.: H03F 1/02, H03K 7/08, H03F 3/189, H02M 3/158, H02M 1/00

(54) **POWER SUPPLY CIRCUIT FOR PROVIDING DRAIN VOLTAGE TO POWER AMPLIFIER IN WIRELESS COMMUNICATION SYSTEM, AND ELECTRONIC DEVICE COMPRISING POWER SUPPLY CIRCUIT**

(30) Priority: 14.11.2022 KR 20220152115
(71) Applicant: Samsung Electronics Co., Ltd., Suwon-si, Gyeonggi-do 16677 (KR)
(72) Inventor: LEE, Jaejin, Suwon-si Gyeonggi-do 16677 (KR); PARK, Jeonggyu, Suwon-si Gyeonggi-do 16677 (KR); PARK, Moohyun, Suwon-si Gyeonggi-do 16677 (KR); CHON, Hyunkyu, Suwon-si Gyeonggi-do 16677 (KR)
(74) Representative: Gulde & Partner
(86) International application number: PCT/KR2023/011905
(87) International publication number: WO 2024/106696

(57) **Abstract**

A power supply circuit is provided in embodiments. The power supply circuit may comprise: a plurality of direct current to direct current (DCDC) converter circuits; and a pulse width modulation (PWM) controller operatively connected to the plurality of DCDC converter circuits. The PWM controller may be configured to obtain the current voltage of a power amplifier (PA). The PWM controller may be configured to obtain a reference voltage for the power amplifier. The PWM controller may be configured to generate PWM control signals for the plurality of DCDC converter circuits on the basis of a difference between the current voltage and the reference voltage. The PWM controller may be configured to provide the PWM control signals to the plurality of DCDC converter circuits.

## Description

### [Technical Field]

The disclosure relates to a power supply circuit of a wireless communication system, and more specifically, to a power supply circuit including a power amplifier that provides a drain voltage and an electronic device including the power supply circuit in a wireless communication system.

### [Background Art]

A direct current to direct current (DCDC) converter refers to a device that converts direct current into direct current. Electronic devices may have different operating voltage ranges. In order to supply a voltage to corresponding different electronic devices, the DCDC converter may need to convert a voltage into different direct currents (DCs).

The above-described information may be provided as related art for the purpose of helping to understand the present disclosure. No claim or determination is raised as to whether any of the above-described information can be applied as a prior art related to the present disclosure.

### [Disclosure]

### [Technical Solution]

In embodiments, a power supply circuit is provided. The power supply circuit may comprise a plurality of direct current direct current (DCDC) converter circuits and a pulse width modulation (PWM) controller operatively connected to the plurality of DCDC converter circuits. The PWM controller may be configured to obtain a current voltage of a power amplifier. The PWM controller may be configured to obtain a reference voltage for the power amplifier. The PWM controller may be configured to generate PWM control signals for the plurality of DCDC converter circuits based on a difference between the current voltage and the reference voltage. The PWM controller may be configured to provide the PWM control signals to the plurality of DCDC converter circuits. Each DCDC converter circuit of the plurality of DCDC converter circuits may comprise a transformer, a primary active clamping circuit connected to a primary end of the transformer, and a secondary resonance converter circuit connected to a secondary end of the transformer. The secondary resonance converter circuit may comprise a diode configured to provide a regeneration current from the secondary end of the transformer to an output end of the secondary resonance converter circuit.

In embodiments, an electronic device is provided. The electronic device may comprise a field programmable gate array (FPGA) including a digital predistortion (DPD) circuit, a power amplifier (PA), a plurality of direct current direct current (DCDC) converter circuits, and a pulse width modulation (PWM) controller operatively connected to the FPGA, the power amplifier, and the DCDC converter circuits. The PWM controller may be configured to obtain a current voltage of the power amplifier. The PWM controller may be configured to obtain a reference voltage for the power amplifier from the DPD circuit. The PWM controller may be configured to generate PWM control signals for the plurality of DCDC converter circuits based on a difference between the current voltage and the reference voltage. The PWM controller may be configured to provide the PWM control signals to the plurality of DCDC converter circuits. Each DCDC converter circuit of the plurality of DCDC converter circuits may comprise a transformer, a primary active clamping circuit connected to a primary end of the transformer, and a secondary resonance converter circuit connected to a secondary end of the transformer. The secondary resonance converter circuit may comprise a diode configured to provide a regeneration current from the secondary end of the transformer to an output end of the secondary resonance converter circuit.

### [Description of the Drawings]

The above and other aspects, features, and advantages of certain embodiments of the disclosure will be more apparent from the following description taken in conjunction with the accompanying drawings, in which:
FIG. 1 illustrates a wireless communication system according to one or more embodiments;
FIG. 2 illustrates a fronthaul interface according to one or more embodiments;
FIGS. 3A and 3B illustrate an example of a wireless communication circuit including a multi-parallel resonance type converter according to one or more embodiments;
FIG. 4 illustrates a functional configuration of an electronic device including a multi- parallel resonance type converter according to one or more embodiments;
FIG. 5 illustrates an example of a pulse width modulation (PWM) for each channel of a multi-parallel resonance type converter according to one or more embodiments;
FIG. 6 illustrates an example of a PWM controller of a multi-parallel resonance type converter according to one or more embodiments;
FIGS. 7A and 7B illustrate an example of a DCDC converter circuit for each channel of a multi-parallel resonance type converter according to one or more embodiments;
FIG. 8 illustrates an example of response speed of a multi-parallel resonance type converter according to one or more embodiments; and
FIGS. 9A, 9B, and 9C are diagrams for explaining the performance of a multi-parallel resonance type converter according to one or more embodiments.

### [Mode for Invention]

The terms used in the disclosure are used only to describe specific embodiments and may not be intended to limit the scope of other embodiments. Singular expressions may include plural expressions unless the context clearly dictates otherwise. Terms used herein, including technical or scientific terms, may have the same meaning as those generally understood by those skilled in the art described herein. Among the terms used in the disclosure, terms defined in a general dictionary may be interpreted as having the same or similar meaning as the meaning in the context of the related art, and are not to be interpreted in an ideal or excessively formal meaning unless clearly defined in the disclosure. In some cases, even terms defined in the disclosure cannot be interpreted to exclude embodiments of the disclosure.

In various embodiments of the disclosure described below, a hardware approach method will be described as an example. However, since various embodiments of the disclosure include technology that uses both hardware and software, various embodiments of the disclosure do not exclude a software-based approach.

Terms referring to a circuit (e.g., communication circuit, resonance circuit, wireless communication circuit, clamping circuit, converter circuit), terms referring to resource (e.g., symbol, period, cycle, duty, interval), terms referring to an operational state (e.g., step, operation, procedure), terms referring to a part (e.g., circuit, chip, integrated circuit (IC), logic circuit), terms referring to a channel, terms referring to a network entity, and terms referring to a component of a device used in the following description are illustrated for convenience of explanation . Therefore, the disclosure is not limited to the terms to be described below, and other terms having an equivalent technical meaning may be used.

In addition, in the disclosure, expressions 'greater than' or 'less than' may be used to determine whether a specific condition is satisfied or fulfilled, but this is only a description for expressing an example and does not exclude the description 'greater than or equal to' or 'less than or equal to'. Conditions described as 'greater than or equal to' may be replaced with 'greater than', conditions described as 'less than or equal to' may be replaced with 'less than', and conditions described as 'greater than or equal to and less than' may be replaced with 'greater than and less than or equal to'. In addition, hereinafter, 'A' to 'B' means at least one of elements from A to (including A) from B (including B). Hereinafter, 'C' and/or 'D' means including at least one of 'C' or 'D', that is, {'C', 'D', 'C' and 'D'}.

The disclosure describes various embodiments using terms (e.g., 3rd Generation Partnership Project (3GPP), European Telecommunications Standards Institute (ETSI), extensible radio access network (xRAN), open-radio access network (O-RAN)) used in some communication standards, but it is only an example for explanation. Various embodiments of the disclosure may be easily modified and applied, even in another communication system.

Hereinafter, the disclosure relates to an apparatus and a method for providing a drain voltage at high speed to a power amplifier (PA) in a wireless communication system. Specifically, the disclosure describes a technology to provide a drain voltage at high speed and reduce switching loss and electromagnetic interference by interleaving a plurality of DCDC converter circuits using a resonance type converter in parallel in a wireless communication system. Hereinafter, in order to explain a circuit and a device for supplying power to the PA of the disclosure, an electronic device to which the circuit and device are applied and the communication environment of the electronic device are described.

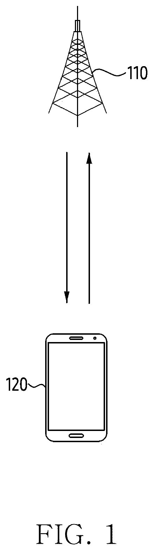

FIG. 1 illustrates a wireless communication system according to one or more embodiments.

Referring to FIG. 1, FIG. 1 illustrates a base station 110 and a terminal 120 as a part of nodes using a wireless channel in a wireless communication system. FIG. 1 illustrates only one base station, but a wireless communication system may further include another base station identical to or similar to the base station 110.

The base station 110 is a network infrastructure that provides wireless access to the terminal 120. The base station 110 has coverage defined based on a distance capable of transmitting a signal. The base station 110 may be referred to as 'access point (AP)', 'eNodeB, (eNB)', and '5th generation node', 'eNodeB (eNB)', '5th generation node', 'next generation nodeB, (gNB)', 'wireless point', 'transmission/reception point (TRP)', or other terms with the same technical meaning, in addition to the base station.

The terminal 120 is a device used by a user and performs communication with the base station 110 through a wireless channel. A link from the base station 110 to the terminal 120 is referred to as downlink (DL), and a link from the terminal 120 to the base station 110 is referred to as uplink (UL). In one embodiment, the terminal 120 and another terminal may perform communication through a wireless channel between each other. At this time, a link (device-to-device link, D2D) between the terminal 120 and another terminal is referred to as a sidelink, and the sidelink may be mixed with PC5 interface. In some other embodiments, the terminal 120 may be operated without user involvement. According to an embodiment, the terminal 120 is a device that performs machine type communication (MTC) and may not be carried by a user. In addition, according to an embodiment, the terminal 120 may be a narrowband (NB)- Internet of Things (IoT) device.

The terminal 120 may be referred to as 'user equipment (UE), 'customer premises equipment (CPE), 'mobile station', 'subscriber station', 'remote terminal', 'wireless terminal', 'electronic device', 'user device', or other terms with the same technical meaning, in addition to the terminal.

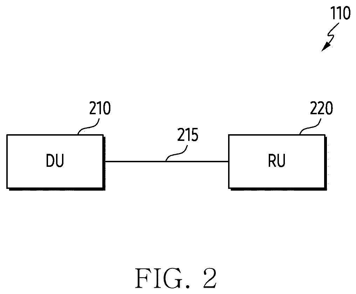

Conventionally, in a communication system having a relatively large cell radius of a base station, each base station has installed so that each base station includes functions of a digital processing unit (or distributed unit (DU)) and a radio frequency (RF) processing unit (or radio unit (RU)). However, as high frequency bands are used in 4th generation (4G) and/or later communication systems (e.g., 5G) and cell coverage of base stations decreases, the number of base stations to cover a specific area has increased. Operators' burden of installation costs for installing base stations has also increased. In order to minimize the installation cost of the base station, a structure in which the DU and RU of the base station are separated, one or more RUs are connected to one DU through a wired network, and one or more geographically distributed RUs are disposed to cover a specific area is proposed. Hereinafter, an arrangement structure and extended examples of a base station according to various embodiments of the disclosure will be described with reference to FIG. 2.

FIG. 2 illustrates a fronthaul interface according to one or more embodiments. Fronthaul refers to an interface between a radio access network and an entity of a base station, unlike backhaul between the core network and the base station. FIG. 2 illustrates an example of a fronthaul structure between DU 210 and one RU 220, but it is only for convenience of explanation and the disclosure is not limited thereto. In other words, an embodiment of the disclosure may also be applied to a fronthaul structure between one DU and a plurality of RUs. For example, an embodiment of the disclosure may be applied to a fronthaul structure between one DU and two RUs. In addition, an embodiment of the disclosure may be applied to a fronthaul structure between one DU and three RUs.

Referring to FIG. 2, the base station 110 may include the DU 210 and the RU 220. A fronthaul 215 between the DU 210 and the RU 220 may be operated through an Fx interface. For example, an interface such as enhanced common public radio interface (eCPRI) and radio over Ethernet (ROE) may be used for operation of the fronthaul 215.

Mobile data traffic increased as communication technology developed, and as a result, bandwidth requirement required by the fronthaul between digital unit and wireless unit increased significantly. In arrangement such as a centralized/cloud radio access network (C-RAN), the DU may be implemented to further perform functions for packet data convergence protocol (PDCP), radio link control (RLC), media access control (MAC), and physical (PHY), and the RU may be implemented to further perform functions for PHY layer in addition to the radio frequency (RF) function.

The DU 210 may be in charge of an upper layer function of the wireless network. For example, the DU 210 may perform a function of the MAC layer and a part of the PHY layer. Herein, a part of the PHY layer is performed at a higher level among functions of the PHY layer, and may include channel encoding (or channel decoding), scrambling (or descrambling), modulation (or demodulation), and layer mapping (or layer de-mapping) as an example. According to an embodiment, if the DU 210 conforms to the O-RAN standard, it may be referred to as an O-RAN DU (O-DU). In embodiments of the disclosure, the DU 210 may be represented by being replaced with a first network entity for a base station (e.g., gNB) as necessary.

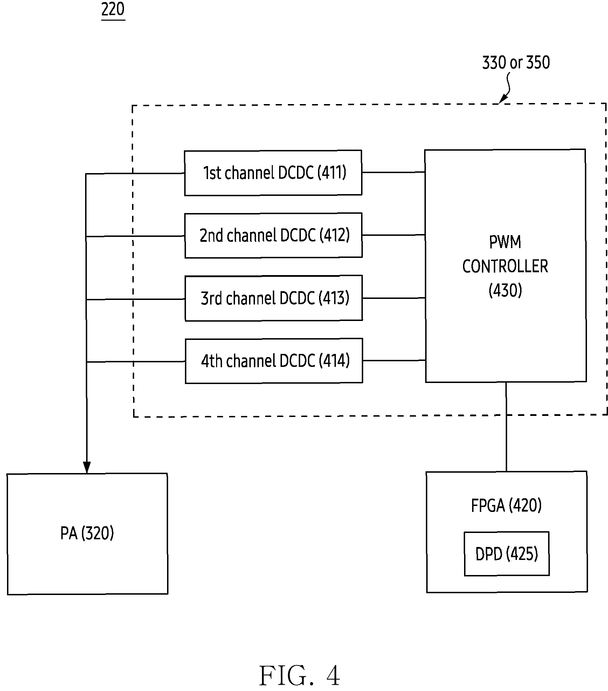

The RU 220 may be in charge of a low layer function of the wireless network. For example, the RU 220 may perform a part of functions of the PHY layer and an RF function. Herein, a part of the PHY layer is performed at a relatively lower level than the DU 210 among the functions of the PHY layer, and include iFFT conversion (or FFT conversion), CP insertion (CP removal), and digital beamforming as an example. An example of specific functional separation is described in detail in FIG. 4. The RU 220 may be referred to as 'access unit (AU), 'access point (AP), 'transmission/reception point (TRP)', 'remote radio head (RRH)', 'radio unit (RU)', or other terms with the same technical meaning. According to an embodiment, if the RU 220 conforms to the O-RAN standard, it may be referred to as an O-RAN RU (O-RU). In embodiments of the disclosure, the RU 220 may be represented by being replaced with a second network entity for a base station (e.g., gNB) as necessary.

FIG. 2 describes that the base station 110 includes the DU 210 and the RU 220, but embodiments of the disclosure are not limited thereto. According to the embodiments, a base station may be implemented in a distributed deployment according to a centralized unit (CU) configured to perform a function of an upper layer (e.g. packet data convergence protocol (PDCP), radio resource control (RRC)) of an access network and a distributed unit (DU) configured to perform a function of a lower layer. In this case, the distributed unit (DU) may include a digital unit (DU) and a radio unit (RU) of FIG. 1. The base station may be implemented in a structure arranged in the order of CU, DU, and RU, between a core (e.g., 5G core (5GC) or next generation core (NGC)) network and a radio network (RAN). An interface between the CU and the distributed unit (DU) may be referred to as an F1 interface.

The centralized unit (CU) may be connected to one or more DUs and may be in charge of a function of an upper layer than the DU. For example, the CU may be in charge of radio resource control (RRC) and packet data convergence protocol (PDCP) layer functions, and the DU and RU may be in charge of lower layer functions. The DU may perform a part of functions (high PHY) of radio link control (RLC), media access control (MAC), and physical (PHY) layers, and the RU may be in charge of remaining functions (low PHY) of the PHY layer. Also, as an example, the digital unit (DU) may be included in a distributed unit (DU) according to a distributed deployment implementation of a base station. Hereinafter, operations of a digital unit (DU) and an RU are described unless otherwise defined, various embodiments of the disclosure may be applied to both a base station deployment including the CU or a deployment in which the DU is directly connected to a core network (i.e., CU and DU are integrated and implemented as a base station (e.g., NG-RAN node), which is one entity).

Since a PA of a network equipment (e.g., the base station 110 or the RU 220) uses most of the power of the network equipment, research is being conducted to increase the efficiency of the PA. Envelope tracking technology is a technology that increases the efficiency of the PA by tracking amplitude of a RF signal and adjusting a bias voltage of the amplifier based on the tracking results. According to variable output of the PA, a drain voltage of a transistor of the PA may be variably provided. However, in order to change the drain voltage of the PA to a reference voltage (e.g., 48V) at a very high speed, a very large current change must be provided by an input capacitor with respect to a drain end of the PA. Herein, the reference voltage refers to a target voltage to be provided by a power supply circuit. In order to change the current, a large space for heat dissipation, a large power semiconductor with high performance, and components (e.g., resistors, inductors, and capacitors) are required. For example, when the drain capacitor is 5uF, 100 ampere (A)/500 nanosecond(ns) supply may be required.

As described above, in envelope tracking technology to increase the efficiency of the PA, a large space and high-performance power devices are required to directly vary the drain voltage in real time. Due to spatial design constraints or large parasitic inductance characteristics of large components, achieving maximum efficiency is difficult. As a method of achieving the efficiency of an appropriate level (about 60% of the maximum efficiency), a multi-step tracking method using an appropriate number (e.g., 2, 3) of general DCDC circuits may be used. A plurality of voltage levels to be used in the drain voltage are preset, and a circuit according to the multi-step tracking method may supply one of various voltages according to the system output to the drain of the PA through a switch. As the plurality of voltage levels are selectively provided, efficiency may be maintained at the appropriate level. However, since the drain voltage may not meet all the output conditions of the system, achieving optimal efficiency is difficult. In addition, since a plurality of power supply units with different voltage values are required, the multi-step tracking method is still disadvantageous in terms of space.

In order to solve the above problems, embodiments of the disclosure propose a multi-parallel resonance type converter to provide efficient space utilization and high-speed response performance. The multi-parallel resonance type converter may include DCDC converter circuits arranged in parallel. Herein, each DCDC converter circuit may include two or more resonance type converters centered on a transformer. The DCDC converter circuits may be interleaved through a PWM controller.

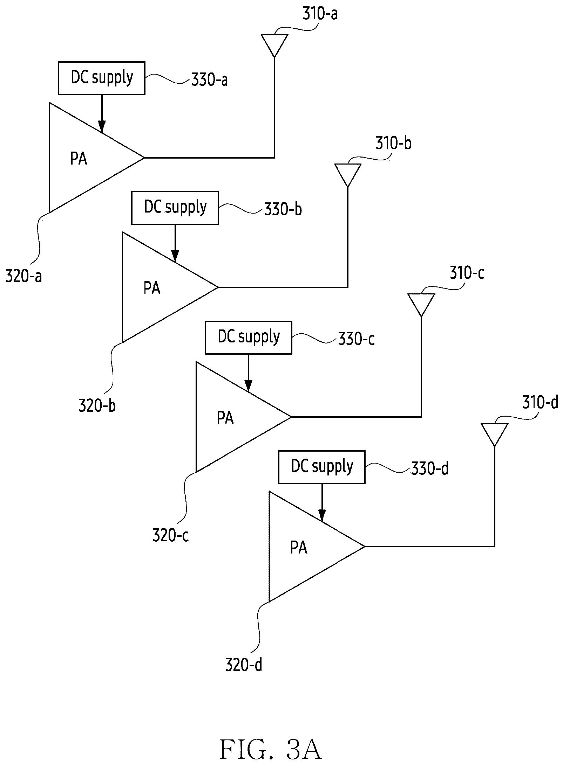

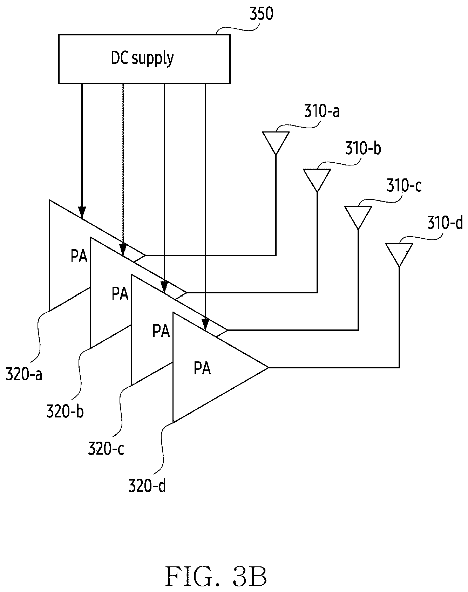

FIGS. 3A and 3B illustrate an example of a wireless communication circuit including a multi-parallel resonance type converter according to one or more embodiments. Terms such as '...unit', '... er' used below refer to a unit that processes at least one function or operation, and it may be implemented in hardware or software, or a combination of hardware and software.

Referring to FIG. 3A, an electronic device (e.g., the RU 220) may include a plurality of transmission paths. Each transmission path may include a PA and an antenna (or a radiator). For example, a first transmission path may include a first PA 320-a and a first antenna 310-a. A second transmission path may include a second PA 320-b and a second antenna 310-b. A third transmission path may include a third PA 320-c and a third antenna 310-c. A fourth transmission path may include a fourth PA 320-d and a fourth antenna 310-d.

The electronic device (e.g., the RU 220) may include a power supply circuit for each transmission path. The electronic device (e.g., the RU 220) may include a power supply circuit for each PA. In order to provide a voltage to be supplied to the drain of the PA, a power supply circuit may be connected to the PA. For example, the electronic device (e.g., the RU 220) may include a first power supply circuit 330-a for the first PA 320-a. The electronic device (e.g., the RU 220) may include a second power supply circuit 330-b for the second PA 320-b. The electronic device (e.g., the RU 220) may include a third power supply circuit 330-c for the third PA 320-c. The electronic device (e.g., the RU 220) may include a fourth power supply circuit 330-d for the fourth PA 320-d. According to an embodiment, the power supply circuit may include a DCDC converter. The power supply circuit may be referred to as a DC supply, a DC power unit, a power supply unit, a power supplier, a DC power supply unit, or a term having the same technical meaning.

Hereinafter, in order to explain each of the first PA 320-a, the second PA 320-b, the third PA 320-c, and the fourth PA 320-d, a description of the PA 320 may be provided. The description of the PA 320 may be understood as a description of an individual PA. In addition, hereinafter, a description of the first power supply circuit 330 may be provided to explain each of the first power supply circuit 330-a, the second power supply circuit 330-b, the third power supply circuit 330-c, and the fourth power supply circuit 330-d. The description of the first power supply circuit 330 may be understood as a description of an individual power supply circuit.

Although an example in which the individual power supply circuit for each PA is arranged is described in FIG. 3A, embodiments of the disclosure are not limited thereto. Referring to FIG. 3B, according to another embodiment, the electronic device (e.g., the RU 220) may include one power supply circuit for a plurality of PAs. For example, the electronic device (e.g., the RU 220) may include a fifth power supply circuit 350 for the first PA 320-a, the second PA 320-b, the third PA 320-c, and the fourth PA 320-d.

FIG. 4 illustrates a functional configuration of an electronic device (e.g., the RU 220) including a multi- parallel resonance type converter according to one or more embodiments. Terms such as '...unit', '... er' used below refer to a unit that processes at least one function or operation, and it may be implemented in hardware or software, or a combination of hardware and software.

Referring to FIG. 4, the electronic device (e.g., the RU 220) may include a field Programmable Gate Array (FPGA) 420. A digital predistortion (DPD) circuit 425 may be implemented on the FPGA 420. The DPD circuit 425 may provide the power supply circuit with a reference voltage required to compensate for non-linearity of the PA (e.g., the PA 320). That is, the DPD circuit 425 may provide the power supply circuit with a reference voltage to be followed by the DCDC converter.

The electronic device (e.g., the RU 220) may include a power supply circuit (e.g., the first power supply circuit 330-a, the second power supply circuit 330-b, the third power supply circuit 330-c, the fourth power supply circuit 330d, or the fifth power supply circuit 350) having a multi-parallel resonance type converter. The power supply circuit may include a plurality of DCDC converters and a PWM controller.

According to an embodiment, each channel DCDC converter among the plurality of DCDC converters may provide a drain voltage for the PA 320. For example, the plurality of DCDC converters may include a first channel DCDC converter 411, a second channel DCDC converter 412, a third channel DCDC converter 413, and a fourth channel DCDC converter 414. Each of the plurality of DCDC converters may be connected to the PA 320. According to an embodiment, in order to implement FET switching at high speed with insulation characteristics, each channel DCDC converter may include a transformer (or a coupled inductor). Each channel DCDC converter may include a primary converter circuit, the transformer, and a secondary converter circuit. The primary converter circuit and the secondary converter circuit may be isolated from each other through the transformer.

According to an embodiment, the PWM controller may be coupled to the plurality of DCDC converters. For example, the PWM controller may include a PWM controller 430 coupled to the first channel DCDC converter 411, the second channel DCDC converter 412, the third channel DCDC converter 413, and the fourth channel DCDC converter 414. In order to minimize loss during switching, the plurality of DCDC converters may be connected with the PWM controller 430 in parallel. According to an embodiment, in order to control an active time of each of the plurality of DCDC converters, the PWM controller 430 may provide the PWM control signal to each of the plurality of DCDC converters. The PWM control signal may be applied as a gate voltage with respect to transistors (e.g., FETs) of each channel DCDC converter. The PWM controller 430 may include a control circuit (e.g., integrated circuit, IC) for interleaving of a plurality of channels. The PWM controller 430 may generate a PWM control signal for controlling an output voltage to each channel DCDC converter.

According to an embodiment, the PWM controller 430 may receive an input for a reference voltage and an input for a voltage of the current PA 320. The reference voltage refers to a target voltage to be provided by the power supply circuit. The PWM controller 430 may generate PWM control signals with parameters (e.g., amplitude, period) determined based on the reference voltage and the voltage of the current PA 320.

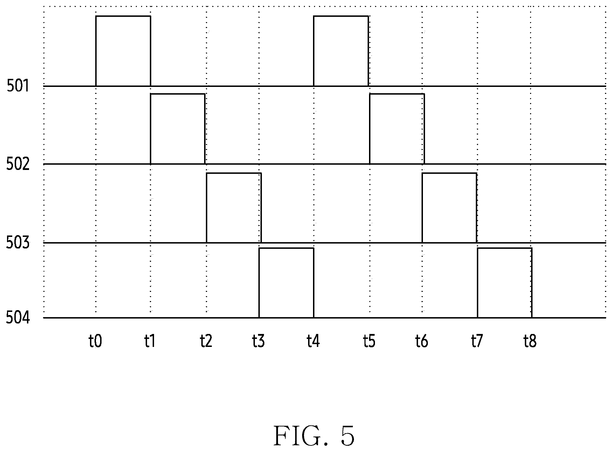

FIG. 5 illustrates an example of a pulse width modulation (PWM) for each channel of a multi-parallel resonance type converter according to one or more embodiments. In FIG. 5, four PWM control signals may be used for the four DCDC converters illustrated in FIG. 4.

Referring to FIG. 5, a power supply circuit including the multi-parallel resonance type converter may generate a first PWM control signal 501 for a first channel DCDC converter (e.g., the first channel DCDC converter 411). The power supply circuit may generate a second PWM control signal 502 for a second channel DCDC converter (e.g., the second channel DCDC converter 412). The power supply circuit may generate a third PWM control signal 503 for a third channel DCDC converter (e.g., the third channel DCDC converter 413). The power supply circuit may generate a fourth PWM control signal 504 for a fourth channel DCDC converter (e.g., the fourth channel DCDC converter 414).

One period may be P ( = t4-t0 = t8-t4). When one period is referred to as a 2π radian, each PWM control signal may be moved 90 degrees (= π/4 radian) to supply power throughout the period. For example, the power supply circuit may generate a first PWM control signal 501 in a basic (i.e., 0 degrees). A pulse of the first PWM control signal 501 may be generated from a time point t0 to a time point t1. A length of the pulse of the first PWM control signal 501 may correspond to 1/4 of the one period. In addition, the power supply circuit may generate a second PWM control signal 502 whose phase is shifted 90 degrees from the first PWM control signal 501. The pulse of the second PWM control signal 502 may be generated from the time point t1 to a time point t2. A length of the pulse of the second PWM control signal 502 may correspond to 1/4 of the one period. In addition, the power supply circuit may generate a third PWM control signal 503 whose phase is shifted 90 degrees from the second PWM control signal 502. A pulse of the third PWM control signal 503 may be generated from the time point t2 to the time point t3. A length of the pulse of the third PWM control signal 503 may correspond to 1/4 of the one period. In addition, the power supply circuit may generate a fourth PWM control signal 504 whose phase is shifted 90 degrees from the third PWM control signal 503. A pulse of the fourth PWM control signal 504 may be generated from the time point t3 to the time point t4. A length of the pulse of the fourth PWM control signal 504 may correspond to 1/4 of the one period. The pulses generated during one period from the time point t0 to time point t4 may also be repeated in the next period (e.g., a period from time point t4 to time point t8).

Although the PWM control signal for each of the four channels is described in FIG. 5, embodiments of the disclosure are not limited thereto. According to embodiments, PWM control signals that move sequentially by 360/X degrees may be used when X DCDC converters for X channels are interleaved. For example, six PWM control signals may be used for the DCDC converter of each channel. When the six PWM control signals are aligned, the aligned six PWM control signals may be sequentially shifted in phase by 60 degrees. For another example, eight PWM control signals may be used for the DCDC converter of each channel. When the eight PWM control signals are aligned, the aligned eight PWM control signals may be sequentially shifted in phase by 45 degrees.

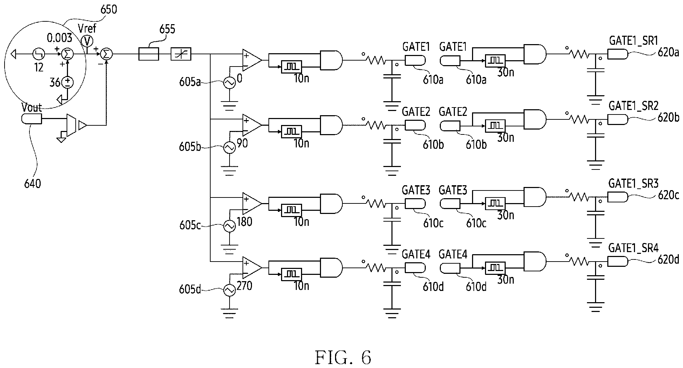

FIG. 6 illustrates an example of a PWM controller of a multi-parallel resonance type converter according to one or more embodiments.

Referring to FIG. 6, a power supply circuit (e.g., the first power supply circuit 330-a, the second power supply circuit 330-b, the third power supply circuit 330-c, the fourth power supply circuit 330d, or the fifth power supply circuit 350) may include a PWM controller (e.g., the PWM controller 430). According to an embodiment, the PWM controller 430 may obtain an input voltage 640. The input voltage 640 may refer to a voltage (hereinafter, a 'current voltage') currently supplied to a PA (e.g., the PA 310). According to an embodiment, the PWM controller 430 may obtain a reference voltage 650. The reference voltage 650 refers to a target voltage to be provided by the power supply circuit. For example, the PWM controller 430 may receive information on the reference voltage 650 required by the PA 320 for a RF output symbol at every moment from a DPD circuit (e.g., the DPD circuit 425). The reference voltage 650 refers to a target value of a drain voltage to be supplied to a PA (e.g., the PA 320). The PWM controller 430 may generate PWM control signals based on a difference between the input voltage 640 and the reference voltage 650.

The difference between the input voltage 640 and the reference voltage 650 may be provided to individual amplification circuits through a Proportional-Integral (PI) control circuit 655. The individual amplification circuit may be used to generate a PWM control signal for a gate voltage of each channel DCDC converter. The PWM controller 430 may provide the difference between the input voltage 640 and the reference voltage 650 to the individual amplification circuit to generate a PWM control signal. The individual amplification circuit may include a power source, an amplifier, a logic gate, and an RC circuit.

The PWM controller 430 may generate a PWM control signal for each of a plurality of DCDC converters. For example, the plurality of DCDC converters may include the first channel DCDC converter 411, the second channel DCDC converter 412, the third channel DCDC converter 413, and the fourth channel DCDC converter 414. The PWM controller 430 may generate PWM control signals by generating a duty cycle with a certain control gain. The PWM controller 430 may provide a PWM control signal for the DCDC converter of each channel. According to an embodiment, the PWM controller 430 may perform phase transition on at least a part of the plurality of DCDC converters to cover one period (e.g., 360 degrees). For example, the plurality of DCDC converters may be X number. The PWM controller 430 may generate PWM control signals sequentially shifting by 360/X degrees to interleave X DCDC converters. For example, the PWM controller 430 may generate PWM control signals in which a phase is shifted sequentially by 90 degrees for the four DCDC converters.

For interleaving of the plurality of DCDC converters, source power providing different phase conversions may be inputted to an individual amplifier. For example, the PWM controller 430 may include a first source 605a. In order to generate a first PWM control signal for the first channel DCDC converter 411, the first source 605a may provide a power source having a phase of 0 degrees to the first amplifier. The output of the first amplifier may be provided to a first gate 610a through a logic gate and an RC circuit. That is, a first PWM control signal (e.g., the first PWM control signal 501) may be applied to the first gate 610a. The PWM controller 430 may include a second source 605b. In order to generate a second PWM control signal for the second channel DCDC converter 412, the second source 605b may provide a power source having a phase of 90 degrees to the second amplifier. The output of the second amplifier may be provided to a second gate 610b through the logic gate and the RC circuit. That is, a second PWM control signal (e.g., the second PWM control signal 502) may be applied to a second gate 610b. The PWM controller 430 may include a third source 605c. In order to generate a third PWM control signal for the third channel DCDC converter 413, the third source 605c may provide power source having a phase of 180 degrees to the third amplifier. The output of the third amplifier may be provided to a third gate 610c through the logic gate and the RC circuit. That is, a third PWM control signal (e.g., the third PWM control signal 503) may be applied to the third gate 610c. The PWM controller 430 may include a fourth source 605d. In order to generate a fourth PWM control signal for the fourth channel DCDC converter 414, the fourth source 605d may provide a power source having a phase of 270 degrees to the fourth amplifier. The output of the fourth amplifier may be provided to a fourth gate 610d through the logic gate and the RC circuit. That is, a fourth PWM control signal (e.g., the fourth PWM control signal 504) may be applied to the fourth gate 610d.

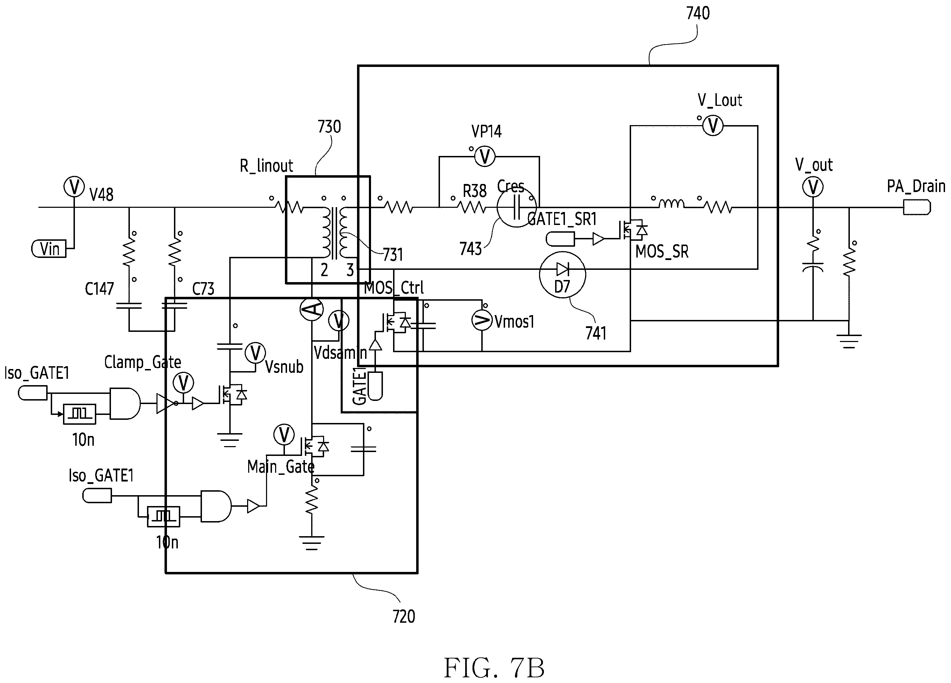

A secondary end circuit (e.g., a resonance converter circuit) of each channel DCDC converter of the plurality of DCDC converters may include a synchronous rectifier. A separate gate voltage may be required to activate the synchronous rectifier. For example, the output of the first gate 610a may be provided to a first gate_SR 620a through the logic gate and the RC circuit. The output of the first gate_SR 620a may be used to activate a synchronous rectifier (e.g., MOS_SR in FIG. 7B) of the first channel DCDC converter 411. In addition, the output of the second gate 610b may be provided to a second gate_SR 620b through the logic gate and the RC circuit. The output of the second gate_SR 620b may be used to activate a synchronous rectifier of the second channel DCDC converter 412. In addition, the output of the third gate 610c may be provided to a third gate_SR 630c through the logic gate and the RC circuit. The output of the third gate_SR 630c may be used to activate a synchronous rectifier of the third channel DCDC converter 413. In addition, the output of the fourth gate 610d may be provided to a fourth gate_SR 620d through the logic gate and the RC circuit. The output of the fourth gate_SR 620d may be used to activate a synchronous rectifier of the fourth channel DCDC converter 414.

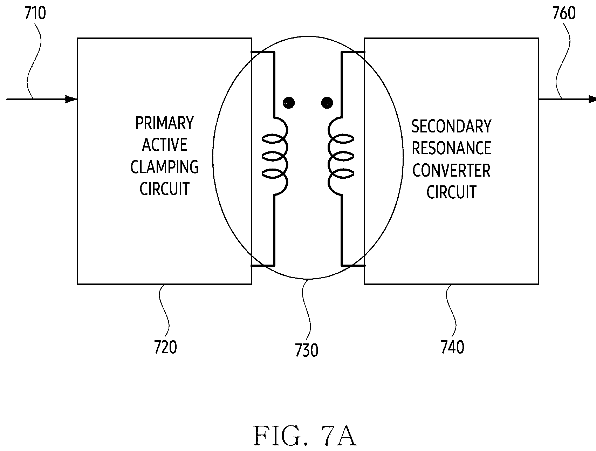

FIGS. 7A and 7B illustrate an example of a DCDC converter circuit for each channel of a multi-parallel resonance type converter according to one or more embodiments. The DCDC converter circuit described in FIGS. 7A to 7B illustrates one of the first channel DCDC converter 411, the second channel DCDC converter 412, the third channel DCDC converter 413, and the fourth channel DCDC converter 414 of FIG. 4.

Referring to FIG. 7A, the DCDC converter circuit may include a primary end circuit (a circuit including an input end) and a secondary end circuit (a circuit including an output end) isolated through a transformer 730. According to an embodiment, the DCDC converter circuit may include a forward converter in which power is directly transmitted to the secondary end circuit in case that the switch of the primary end circuit is turned on. In order to reduce switching loss through zero-voltage switching (ZVS) when switching at high speed, both the primary end circuit and the secondary end circuit may include a resonance circuit. According to an embodiment, the DCDC converter may include a primary active clamping circuit 720 at the primary end based on a transformer. The DCDC converter may include a secondary resonance converter circuit 740 at the secondary end based on the transformer. Hereinafter, the DCDC converter circuit according to the embodiments of the disclosure may include the primary active clamping circuit 720, the transformer 730, and the secondary resonance converter circuit 740. The primary active clamping circuit 720 and the secondary resonance converter circuit 740 may be isolated from each other through the transformer 730.

According to an embodiment, the primary active clamping circuit 720 may receive an input 710. The input 710 may include a PWM control signal provided from a PWM controller (e.g., the PWM controller 430). The input 710 may be a first control FET of the primary active clamping circuit 720. The input 710 may include a gate signal for driving each of a first control FET (or main FET) and a clamp FET of the primary active clamping circuit 720. The first control FET (or the main FET) and the clamp FET may be driven according to a pulse of the input 710. The primary active clamping circuit 720 may transfer a voltage generated based on the input 710 and the reference voltage to the secondary end of the transformer 730. The primary active clamping circuit 720 may include the first control FET. In case that the first control FET is turned on, a voltage may be provided to the secondary resonance converter circuit 740 through the transformer 730. The primary active clamping circuit 720 may include a first resonance capacitor. A source drain voltage Vds of the first control FET may operate at zero voltage through the first resonance capacitor of the primary active clamping circuit 720. Due to operation at zero voltage, switching losses may be reduced.

According to an embodiment, the secondary resonance converter circuit 740 may provide an output 760. The output 760 may include a drain voltage to be supplied to a PA (e.g., the PA 320). The secondary resonance converter circuit 740 may include a second control FET. The secondary resonance converter circuit 740 may include a turn-on delay circuit for the second control FET. The secondary resonance converter circuit 740 may include a resonance circuit. The secondary resonance converter circuit 740 may include a second resonance capacitor for resonance with a leakage inductor by the transformer 730. According to an embodiment, the secondary resonance converter circuit 740 may include a diode (hereinafter, regeneration diode) for suppressing the spike of the source drain voltage (Vds) of the first control FET and regenerating the inverse current of the transformer 730 to the output. Herein, regeneration refers to a technology that reproduces the remaining energy when a current provided from the transformer 730 to a secondary side (e.g., the secondary resonance converter circuit 740) is cut off to the output side (e.g., the secondary resonance converter circuit 740) or input side (e.g., the primary active clamping circuit 720) without consuming the remaining energy in the circuit.

The switching loss of the second control FET may be reduced, through the turn-on delay circuit of the second control FET and the resonance circuit by the second resonance capacitor. In addition, when the FET is quickly switched to respond quickly to the drain voltage of the PA 320, switching loss proportional to the switching frequency may be reduced due to the regeneration diode and the second resonance capacitor. Due to the reduced switching loss, efficiency of the DCDC converter may increase and a heating value of the FET may decrease.

Referring to FIG. 7B, an example of a detailed circuit diagram of a DCDC converter including the primary active clamping circuit 720, the transformer 730, and the secondary resonance converter circuit 740 is described.

Referring to FIG. 7B , a reference voltage (e.g., 48V) providing unit and the primary active clamping circuit 720 may be disposed at the primary end based on the transformer 730. A PWM control signal may be applied to the primary active clamping circuit 720 through a gate (e.g., the first gate 610a) described in FIG. 6. In FIG. 7B, for convenience of explanation, although components (e.g., the first PWM control signal 501, the first gate 610a, and the first gate_SR 620a) for the first channel DCDC converter 411 are described as examples, the descriptions in FIG. 7b may be applied to other channel DCDC converters (e.g., the second channel DCDC converter 412, the third channel DCDC converter 413, and the fourth channel DCDC converter 414).

The output of the first gate 610a may be inputted to the primary active clamping circuit 720. Since a forward converter generates voltage spike at both ends of the switch by the energy stored in the leakage inductance of the transformer 730 or magnetizing inductance during the switching operation, excessive voltage stress is applied to the switch in addition to power loss. In order to suppress the voltage stress, the primary active clamping circuit 720 may be used to form a discharge path of energy stored in the leakage inductance or the magnetizing inductance. The primary active clamping circuit 720 may increase power conversion efficiency when the first control FET (Main FET) is cut off, by preventing loss of a switching element due to the energy stored in the leakage inductance or the magnetizing inductance and recycling the energy by operating the clamp FET. In addition, since zero-voltage switching (ZVS) of the first control FET and the clamp FET is possible through the primary active clamping circuit 720, efficiency may be increased and switching heat may be reduced by reducing switching loss.

The output of the first gate 610a may be inputted to the secondary resonance converter circuit 740. According to an embodiment, the secondary resonance converter circuit 740 may include a delay circuit for the second control FET (MOS_Ctrl). According to an embodiment, the secondary resonance converter circuit 740 may include a resonance circuit. The resonance circuit may include a second resonance capacitor 743 to form resonance with the leakage inductance by the secondary inductor 731 of the transformer 730. Through the delay circuit for the second control FET and the resonance circuit by the second resonance capacitor 743, the switching loss of the second control FET may be reduced. According to an embodiment, the secondary resonance converter circuit 740 may include a regeneration diode 741 for a regeneration current provided from the transformer 730 to the output end (V_out). The regeneration diode 741 may clamp the spike voltage (Vds) generated when the second control FET is turned off and regenerate the inverse current of the transformer 730 in the output. In addition, the output of the first gate_SR 620a may be applied to the synchronous rectifier (MOS_SR). Efficiency may be improved through a voltage drop of the second control FET (MOS_Ctrl) through the synchronous rectifier. In one embodiment, a voltage (V_out) of the output end of the secondary resonance converter circuit 740 may be provided as the drain voltage (PA_Drain) of the PA 320.

One DCDC converter circuit is described in FIGS. 7A to 7B, but as illustrated in FIG. 4, the first channel DCDC converter 411, the second channel DCDC converter 412, the third channel DCDC converter 413, and the fourth channel DCDC converter 414 may be connected in parallel. In order to follow a reference voltage (i.e., drain voltage of the amplifier), the DCDC converters of each channel may operate while interleaving phases by 90 degrees, by the PWM control signals (e.g., output of the first gate 610a of FIG. 6, output of the second gate 610b, output of the third gate 610c, output of the fourth gate 610d) of the PWM controller 430. In order to quickly follow the reference voltage, the DCDC converter of each channel may provide fast response performance through high-speed switching. Since the PWM is changed every 90 degrees, the ripple of the output voltage may be reduced, and the response speed of the control may be increased.

According to embodiments, the PWM controller 430 may control a plurality of DCDC converters (e.g., the first channel DCDC converter 411, the second channel DCDC converter 412, the third channel DCDC converter 413, and the fourth channel DCDC converter 414). Each of the PWM control signals (e.g., the output of the first gate 610a, the output of the second gate 610b, the output of the third gate 610c, and the output of the fourth gate 610d of FIG. 6), which are outputs of the PWM controller 430, may be used to drive the control FET of a corresponding DCDC converter.

Through fast phase conversion and regenerating, appropriate commands may be provided at each steps of the drain voltage (PA_Drain) of the PA 320. That is, the power supply device according to embodiments may supply the drain voltage of all steps to the PA 320 at high speed. The input current may be small. Through the sine wave, a size of a line filter may be reduced. Since the secondary end circuit (e.g., the secondary resonance converter circuit 740) also includes a resonance circuit, the size of a LC filter, which is the ripple filter of the output end, may decrease. In addition, since the plurality of DCDC converters are arranged in parallel, a current provided to each channel DCDC converter is supplied in parallel, and IR loss is greatly reduced. Accordingly, since the component size is reduced, the power supply device may be disposed adjacent to the PA 320 and efficiency may be increased.

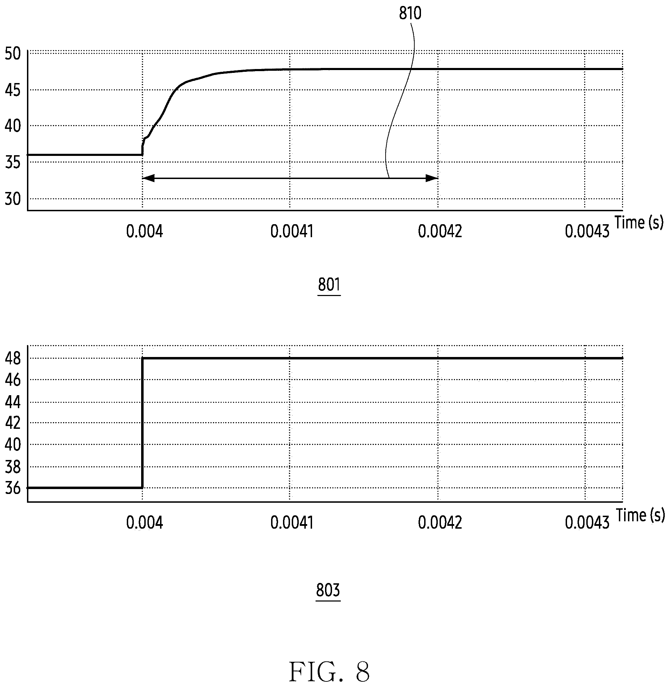

FIG. 8 illustrates an example of response speed of a multi-parallel resonance type converter according to one or more embodiments.

Referring to FIG. 8, the graph 801 represents an output voltage of the power supply device (e.g., the first power supply circuit 330-a, the second power supply circuit 330-b, the third power supply circuit 330-c, the fourth power supply circuit 330d, or the fifth power supply circuit 350) over time. The horizontal axis of the graph 801 represents the time (unit: second), and the vertical axis of the graph 803 represents the voltage (unit: volt (V)). The graph 803 represents a reference voltage over time. A horizontal axis of the graph 803 represents a time (unit: second), and a vertical axis of the graph 803 represents a voltage (unit: V).

The reference voltage may be changed according to an embodiment. For example, the reference voltage may be changed from about 36V to about 48V. Based on the change in the reference voltage, the output voltage of the power supply device may be changed. The output of the power supply device may be changed from about 36V to about 48V. A time when the output of the power supply device is changed from about 36V to about 48V, that is, a time from a previous value of the reference voltage to a current value, may be referred to as a follow-up time 810. A shorter follow-up time may mean a faster follow-up speed. For example, the follow-up time 810 may be about 200 nanoseconds (ns). According to embodiments, the follow-up time 810 of a power supply device including a multi-parallel resonance type converter may be less than about 100 microseconds (us), which is a follow-up time of a conventional method such as a multi-step tracking method. That is, according to the embodiments, the follow-up speed of the power supply device including the multi-parallel resonance type converter may be faster than that of a conventional method such as the multi-step tracking method. All step-by-step drain voltage may be supplied for the RF symbol required by the PA (e.g., the PA 320).

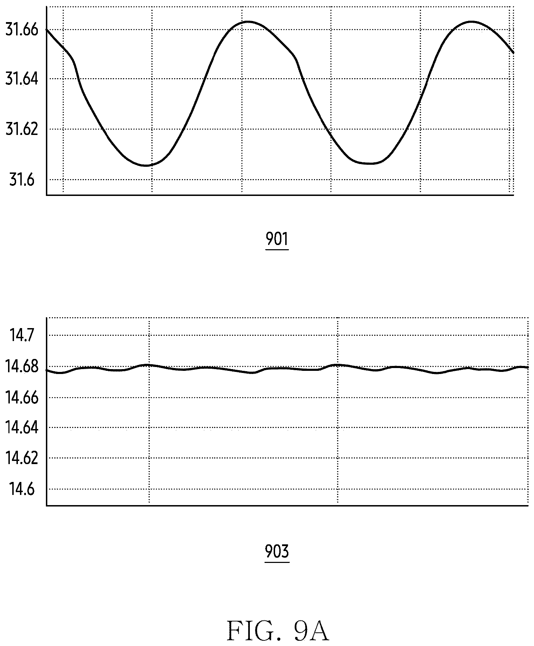

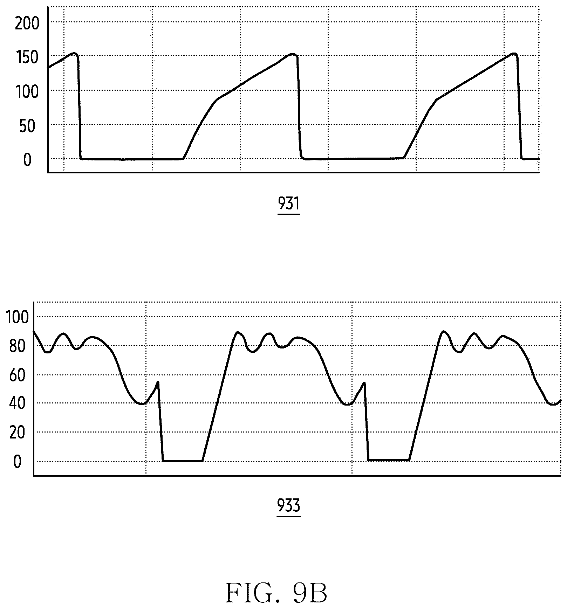

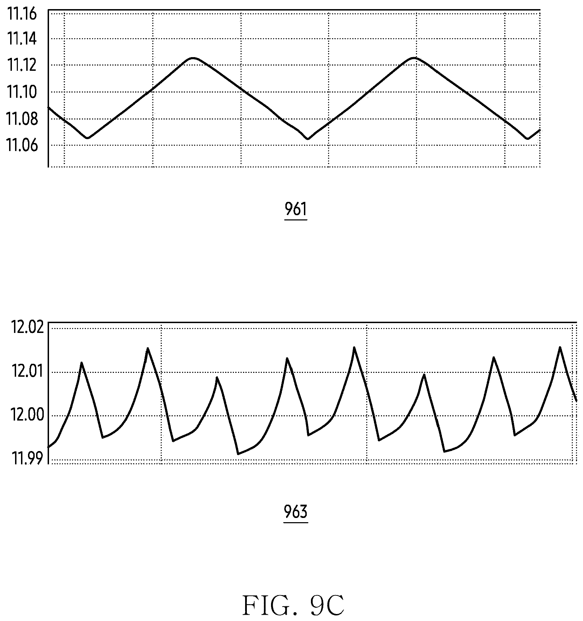

FIGS. 9A, 9B, and9C are diagrams for explaining the performance of a multi-parallel resonance type converter.

Referring to FIG. 9A, the graph 901 represents the input current of the single channel converter, and the graph 903 represents the input current of the multi-parallel resonance type converter. The horizontal axis of the graph 901 represents time, and the vertical axis represents current (unit: ampere (A)). The horizontal axis of the graph 903 represents time, and the vertical axis represents current (unit: A). The input current of the single channel converter has a swing section in the range of about +25 milliampere (mA) to -25 mA. In other words, the input current ripple of the single channel converter is about 50 mA. The input current of the multi-parallel resonance type converter may have a swing section in the range of about +4mA to -4mA. In other words, the input current ripple of the multi-parallel resonance type converter is about 8 mA. Through the graphs 901 and 903, it may be identified that the ripple of the input current using the multi-parallel resonance type converter is reduced. In addition, since the swing width of the input current is reduced to about 1/6 compared to the single channel, the size of the Electromagnetic Compatibility (EMC) filter may also be designed relatively small and noise may be reduced.

Referring to FIG. 9B, the graph 931 represents the source drain voltage of the single channel converter, and the graph 933 represents the source drain voltage of the multi-parallel resonance type converter (i.e., Vds of the FET of the primary active clamping circuit). The horizontal axis of the graph 931 represents time, and the vertical axis represents voltage (unit: V). The horizontal axis of the graph 933 represents time, and the vertical axis represents current (unit: A). The source drain voltage of the single channel converter has a size of about 150V. The source drain voltage of the multi-parallel resonance type converter has a size of about 85V. Since the Vds required for the main FET of the primary active clamping circuit is reduced through the multi-parallel resonance type converter, a transistor (e.g., 100V FET) providing a lower potential difference may be used.

Referring to FIG. 9C, the graph 961 represents the output voltage of the single channel converter, and the graph 963 represents the output voltage of the multi-parallel resonance type converter (i.e., the secondary resonance converter circuit 740). The horizontal axis of the graph 961 represents time, and the vertical axis represents voltage (unit: V). The horizontal axis of the graph 963 represents time, and the vertical axis represents current (unit: A). The output voltage of the single channel converter has a ripple size of about 25 mV. The output voltage of the multi-parallel resonance type converter has a ripple size of about 10mV. Through the graphs 961 and 963, it may be identified that the ripple of the output voltage using the multi-parallel resonance type converter is reduced.

For a real-time RF symbol required by the PA, drain voltage of all steps may be supplied at a high speed of 500ns or less (e.g., 200ns or less). Since the output end of each secondary side also uses a resonance type converter, the size of the LC filter, which is the ripple filter of the output end, may be reduced. Since four DCDC converters are arranged in parallel, each current is supplied in parallel, so IR loss (loss proportional to the square of the current) is greatly reduced. In addition, since the size of components of the power supply device may be reduced, the power source of the PA may be arranged, which is very advantageous in terms of power integration (PI) design. The power supply device according to the embodiments of the disclosure may reduce spatial constraints of the power supply device and reduce EMI by interleaving a plurality of DCDC converters arranged in parallel.

The effects that can be obtained from the disclosure are not limited to those described above, and any other effects not mentioned herein will be clearly understood by those having ordinary knowledge in the art to which the disclosure belongs, from the following description.

According to an embodiment, a power supply circuit may comprise a plurality of direct current direct current (DCDC) converter circuits and a pulse width modulation (PWM) controller. The PWM controller may be configured to obtain a current voltage of a PA. The PWM controller may be configured to obtain a reference voltage for the PA. The PWM controller may be configured to generate PWM control signals for the plurality of DCDC converter circuits based on a difference between the current voltage and the reference voltage. The PWM controller may be configured to provide the plurality of DCDC converter circuits with the PWM control signals. Each DCDC converter circuit of the plurality of DCDC converter circuits may include a transformer, a primary active clamping circuit connected to a primary end of the transformer, and a secondary resonance converter circuit connected to a secondary end of the transformer. The secondary resonance converter circuit may include a diode for a regeneration current to an output end from the secondary end of the transformer.

According to an embodiment, the secondary resonance converter circuit may include a resonance circuit for resonance with a leakage inductance by an inductor of the secondary end of the transformer. The resonance circuit may include a resonance capacitor.

According to an embodiment, the secondary resonance converter circuit may include a second field effect transistor (FET) and a delay circuit for delaying a turn-on of the second FET.

According to an embodiment, the secondary resonance converter circuit may include a synchronous rectifier. The synchronous rectifier may be disposed between the delay circuit and the resonance capacitor.

According to an embodiment, the diode may be configured to clamp a spike voltage that occurs when the second FET is turned off. The diode may be configured to pass the regeneration current occurred from the secondary end of the transformer to the output end.

According to an embodiment, the synchronous rectifier may include a transistor operating according to a synchronous rectifier (SR) control signal. The SR control signal may be generated based on a PWM control signal for a DCDC converter circuit including the synchronous rectifier.

According to an embodiment, the primary active clamping circuit may include a first field effect transistor (FET) and a clamp FET for zero-voltage switching (ZVS). The first FET may operate according to a PWM control signal. The clamp FET may operate according to an inverse signal of the PWM control signal to the clamp FET.

According to an embodiment, one control signal among the PWM control signals may be activated within one period. An output of the DCDC converter circuit corresponding to the one control signal among the plurality of DCDC converter circuits may be provided to the PA as a drain voltage.

According to an embodiment, the plurality of DCDC converter circuits may be connected in parallel to the PWM controller. The PWM control signals may have the duty cycle equally. A size of the duty cycle may be related to the number of the plurality of DCDC converter circuits.

According to an embodiment, the PWM control signals may have different phases. When the phases of the PWM control signals are sequentially aligned within one period, a phase difference between two adjacent PWM control signals may be related to the number of the plurality of DCDC converter circuits.

According to an embodiment, an electronic device may comprise a field programmable gate array including a digital predistortion (DPD) circuit, a power amplifier (PA), a plurality of direct current direct current (DCDC) converter circuits, and a pulse width modulation (PWM) controller. The PWM controller may be configured to obtain a current voltage of a power amplifier (PA). The PWM controller may be configured to obtain a reference voltage for the PA from the DPD circuit. The PWM controller may be configured to generate PWM control signals for the plurality of DCDC converter circuits based on a difference between the current voltage and the reference voltage. The PWM controller may be configured to provide the plurality of DCDC converter circuits with the PWM control signals. Each DCDC converter circuit of the plurality of DCDC converter circuits may include a transformer, a primary active clamping circuit connected to a primary end of the transformer, and a secondary resonance converter circuit connected to a secondary end of the transformer. The secondary resonance converter circuit may include a diode for a regeneration current to an output end from the secondary end of the transformer.

According to an embodiment, the secondary resonance converter circuit may include a resonance circuit for resonance with a leakage inductance by an inductor of the secondary end of the transformer. The resonance circuit may include a resonance capacitor.

According to an embodiment, the secondary resonance converter circuit may include a second field effect transistor (FET) and a delay circuit for delaying a turn-on of the second FET.

According to an embodiment, the secondary resonance converter circuit may include a synchronous rectifier. The synchronous rectifier may be disposed between the delay circuit and the resonance capacitor.

According to an embodiment, the diode may be configured to clamp a spike voltage that occurs when the second FET is turned off. The diode may be configured to pass the regeneration current occurred from the secondary end of the transformer to the output end.

According to an embodiment, the synchronous rectifier may include a transistor operating according to a synchronous rectifier (SR) control signal. The SR control signal may be generated based on a PWM control signal for a DCDC converter circuit including the synchronous rectifier.

According to an embodiment, the primary active clamping circuit may include a first field effect transistor (FET) and a clamp FET for zero-voltage switching (ZVS). The first FET may operate according to a PWM control signal. The clamp FET may operate according to an inverse signal of the PWM control signal to the clamp FET.

According to an embodiment, within one period, one control signal among the PWM control signals may be activated. An output of the DCDC converter circuit corresponding to the one control signal among the plurality of DCDC converter circuits may be provided to the PA as a drain voltage.

According to an embodiment, the plurality of DCDC converter circuits may be connected in parallel to the PWM controller. The PWM control signals may have the duty cycle equally. A size of the duty cycle may be related to the number of the plurality of DCDC converter circuits.

According to an embodiment, the PWM control signals may have different phases. When the phases of the PWM control signals are sequentially aligned within one period, a phase difference between two adjacent PWM control signals may be related to the number of the plurality of DCDC converter circuits.

Methods according to the embodiments described in the claims or specifications of the disclosure may be implemented in the form of hardware, software, or a combination of hardware and software.

When implemented in software, a computer readable storage medium storing one or more programs (software modules) may be provided. One or more programs stored in the computer readable storage medium are configured for execution by one or more processors in the electronic device. The one or more programs include instructions that cause the electronic device to execute methods according to embodiments described in the claims or specification of the disclosure.

These programs (software modules, software) may be stored in random access memory, non-volatile memory including flash memory, read only memory (ROM), electrically erasable programmable read only memory (EEPROM), magnetic disc storage device, compact disc-ROM (CD-ROM), digital versatile discs (DVDs) or other form of optical storage, or magnetic cassette. Alternatively, it may be stored in a memory configured as a combination of some or all of them. In addition, a plurality of each configuration memory may be included.

In addition, the program may be stored in an attachable storage device that may be accessed through a communication network such as the Internet, an intranet, a local area network (LAN), a wide area network (WAN), or a storage area network (SAN), or a communication network configured with a combination thereof. Such a storage device may access a device performing an embodiment of the disclosure through an external port. In addition, a separate storage device on the communication network may access a device performing an embodiment of the disclosure.

In the specific embodiments of the disclosure described above, components included in the disclosure are expressed in singular or plural numbers according to the specific embodiments presented. However, singular or plural expressions are selected appropriately for the presented situation for convenience of explanation, the disclosure is not limited to singular or plural components, and even if it is a component expressed in plural, it may be configured with singular, or even if it is a component expressed in singular, it may be configured with plural.

In the detailed description of the disclosure, specific embodiments have been described. Various modifications are possible without departing from the scope of the disclosure.

## Claims

1. A power supply circuit comprising:
a plurality of direct current direct current (DCDC) converter circuits; and
a pulse width modulation (PWM) controller operatively connected to the plurality of DCDC converter circuits,
wherein the PWM controller is configured to:
obtain a current voltage of a power amplifier,
obtain a reference voltage for the power amplifier,
generate PWM control signals for the plurality of DCDC converter circuits based on a difference between the current voltage and the reference voltage, and
provide the PWM control signals to the plurality of DCDC converter circuits,
wherein each DCDC converter circuit of the plurality of DCDC converter circuits comprises:
a transformer,
a primary active clamping circuit connected to a primary end of the transformer, and
a secondary resonance converter circuit connected to a secondary end of the transformer, and
wherein the secondary resonance converter circuit comprises a diode configured to provide a regeneration current from the secondary end of the transformer to an output end of the secondary resonance converter circuit.

2. The power supply circuit of claim 1, wherein the secondary resonance converter circuit comprises a resonance circuit for resonance with a leakage inductance by an inductor of the secondary end of the transformer, and
wherein the resonance circuit comprises a resonance capacitor.

3. The power supply circuit of claim 2, wherein the secondary resonance converter circuit comprises a second field effect transistor (FET) and a delay circuit configured to delay a turn-on of the second FET.

4. The power supply circuit of claim 3, wherein the secondary resonance converter circuit comprises a synchronous rectifier between the delay circuit and the resonance capacitor.

5. The power supply circuit of claim 4, wherein the diode is further configured to:
clamp a spike voltage that occurs when the second FET is turned off, and
pass the regeneration current from the secondary end of the transformer to the output end of the secondary resonance converter circuit.

6. The power supply circuit of claim 5, wherein the synchronous rectifier further comprises a transistor configured to operate based on a synchronous rectifier (SR) control signal,
wherein the SR control signal is generated based on a PWM control signal for a DCDC converter circuit, and
wherein the DCDC converter circuit comprises the synchronous rectifier.

7. The power supply circuit of claim 1, wherein the primary active clamping circuit comprises a first field effect transistor (FET) and a clamp FET for zero-voltage switching (ZVS),
wherein the first FET is configured to operate based on the PWM control signal, and
wherein the clamp FET is configured to operate based on an inverse signal of the PWM control signal to the clamp FET.

8. The power supply circuit of claim 1, wherein, within one period, one control signal among the PWM control signals is activated, and
wherein an output of the DCDC converter circuit corresponding to the one control signal among the plurality of DCDC converter circuits is provided to the power amplifier as a drain voltage.

9. The power supply circuit of claim 1, wherein the plurality of DCDC converter circuits are connected in parallel to the PWM controller,
wherein duty cycles of the PWM control signals are equal, and
wherein a size of the duty cycles is related to a number of the plurality of DCDC converter circuits.

10. The power supply circuit of claim 9, wherein the PWM control signals have different phases, and
wherein, based on the different phases of the PWM control signals that are sequentially aligned within one period, a phase difference between two adjacent PWM control signals is related to the number of the plurality of DCDC converter circuits.

11. An electronic device comprising:
a field programmable gate array (FPGA) comprising a digital predistortion (DPD) circuit,
a power amplifier;
a plurality of direct current direct current (DCDC) converter circuits; and
a pulse width modulation (PWM) controller operatively connected to the FPGA, the power amplifier, and the DCDC converter circuits,
wherein the PWM controller is configured to:
obtain a current voltage of the power amplifier,
obtain a reference voltage for the power amplifier from the DPD circuit,
generate PWM control signals for the plurality of DCDC converter circuits based on a difference between the current voltage and the reference voltage, and
provide the PWM control signals to the plurality of DCDC converter circuits,
wherein each DCDC converter circuit of the plurality of DCDC converter circuits comprises:
a transformer,
a primary active clamping circuit connected to a primary end of the transformer, and
a secondary resonance converter circuit connected to a secondary end of the transformer, and
wherein the secondary resonance converter circuit comprises a diode configured to provide a regeneration current from the secondary end of the transformer to an output end of the secondary resonance converter circuit.

12. The electronic device of claim 11, wherein the secondary resonance converter circuit comprises a resonance circuit for resonance with leakage inductance by an inductor of the secondary end of the transformer, and
wherein the resonance circuit comprises a resonance capacitor.

13. The electronic device of claim 12, wherein the secondary resonance converter circuit comprises a second field effect transistor (FET) and a delay circuit configured to delay a turn-on of the second FET.

14. The electronic device of claim 13, wherein the secondary resonance converter circuit comprises a synchronous rectifier between the delay circuit and the resonance capacitor.

15. The electronic device of claim 14, wherein the diode is further configured to:
clamp a spike voltage that occurs when the second FET is turned off, and
pass the regeneration current from the secondary end of the transformer to the output end of the secondary resonance converter circuit.
